Europäisches Patentamt

European Patent Office

Office européen des brevets

(19)

(11) Numéro de publication : **0 038 726 B1**

# (12) FASCICULE DE BREVET EUROPÉEN

(45) Date de publication du fascicule du brevet :
02.05.84

(21) Numéro de dépôt : 81400300.0

(22) Date de dépôt : 26.02.81

(51) Int. Cl.³ : **G 01 R 13/40, H 04 N 5/50, G 01 R 13/20**

(54) **Dispositif de mesure et de visualisation de l'amplitude d'un signal basse-fréquence.**

(30) Priorité : 23.04.80 FR 8009159

(43) Date de publication de la demande :
28.10.81 Bulletin 81/43

(45) Mention de la délivrance du brevet :
02.05.84 Bulletin 84/18

(84) Etats contractants désignés :
**BE CH DE GB IT LI NL SE**

(56) Documents cités :
**FR-A- 2 371 104**

(73) Titulaire : **Etablissement Public Télédiffusion de France**
**10, rue d'Oradour-sur-Glane**
**F-75015 Paris (FR)**

(72) Inventeur : **Blanchet, Jacques Roger**
**21, rue de Nancy**
**F-54690 Lay Saint Christophe (FR)**
Inventeur : **Pietri, Jean-Claude**
**33, rue Bataille**
**F-69008 Lyon (FR)**

(74) Mandataire : **Cabinet Martinet**
**62, rue des Mathurins**
**F-75008 Paris (FR)**

EP 0 038 726 B1

Dispositif de mesure et de visualisation de l'amplitude d'un signal basse-fréquence

La présente invention concerne un dispositif de mesure et de visualisation de l'amplitude d'un signal basse-fréquence.

Dans les studios de télévision, il est connu que les opérations surveillent la qualité de l'image de télévision au moyen d'un moniteur vidéo reproduisant sur son écran le programme télédiffusé, mais surveillent également la qualité et la présence du signal sont transmis simultanément avec le signal vidéo composite. Généralement, un second appareil, tel qu'un vumètre, permet de mesurer l'amplitude du signal son et, notamment, de contrôler si l'amplitude du signal son n'est pas supérieure à une tension de seuil de surmodulation. Le zéro du cadran du vumètre est réglé de manière à ce qu'il corresponde à ce seuil de surmodulation et dès que l'aiguille du vumètre dépasse quelques décibels ce zéro, l'opérateur signale une surmodulation indésirable du signal son.

Une telle installation de contrôle oblige l'opérateur à déporter en permanence son regard sur deux appareils. Ceci présente un inconfort notable et peut provoquer des erreurs par manque d'attention soutenue de l'opérateur.

Pour remédier à ces inconvénients, la demande de brevet français FR-A-2 371 104 décrit un récepteur de télévision permettant d'afficher la forme complète de la courbe d'un signal audio sur l'écran de son tube cathodique. Le signal audio est combiné à un signal en dents de scie synchrone des impulsions de synchronisation de ligne. La courbe du signal audio est visualisée dans une barre verticale de l'écran, c'est-à-dire l'amplitude du signal audio varie entre deux points distants de chaque ligne. La distance entre ces deux points doit être relativement faible afin de pouvoir visualiser en même temps une image sur la surface totale de l'écran. L'indication du niveau du signal est donc peu précise. En outre, en raison de l'imbrication du balayage relativement aux trames paires et aux trames impaires, des moyens de déphasage spéciaux doivent être prévus pour supprimer le chevauchement de deux courbes du signal audio visualisées sur l'écran.

La présente invention a pour but d'obvier aux inconvénients précédents en visualisant les variations de l'amplitude du signal basse-fréquence par un index pouvant se déplacer le long d'une barre verticale de l'écran. En outre, les variations de l'amplitude du signal basse-fréquence peuvent être repérées par rapport à un index image fixe représentatif d'un seuil de tension à ne pas dépasser.

A cette fin, le dispositif de mesure et de visualisation de l'amplitude d'un signal basse-fréquence est tel que défini dans la revendication 1.

Selon une réalisation préférée de l'invention, destinée à l'analyse de l'amplitude du signal son du signal vidéo composite dans un studio de télédiffusion, les moyens de visualisation vidéo sont un moniteur vidéo. Le principe de la visualisation de l'amplitude du signal son repose, après éventuellement une mise en forme adéquate du signal son par notamment désymétrisation et amplification logarithmique selon une échelle analogue à celle de mesure d'un vumètre classique, à la comparaison, pour chaque trame, de la tension d'un signal en dents de scie ayant la fréquence de balayage vertical, égale à la fréquence de trame, et de la tension du signal basse-fréquence. Dès qu'il y a égalité, une première impulsion est émise dont la position dans la période de trame est proportionnelle à l'amplitude du signal basse-fréquence. Cette première impulsion a une largeur de préférence égale à la période de ligne du moniteur vidéo. Il suffit alors de détecter la ligne à laquelle appartient la première impulsion dans la trame, par coïncidence avec l'une des secondes impulsions récurrentes à la fréquence de ligne, pour visualiser un point ou un tronçon de ligne dont l'ordonnée le long d'une barre verticale de l'écran du moniteur indique la grandeur relative de l'amplitude du signal basse-fréquence. Cette grandeur relative est de préférence mesurée par rapport à un index de référence fixe visualisé dans la barre verticale. L'index de référence est obtenu selon le principe de comparaison précédent, en comparant la tension du signal en dents de scie et une tension de référence. La tension de référence est égale à un seuil de tension à ne pas dépasser, tel que le seuil de surmodulation pour la visualisation de l'amplitude du signal son.

Il apparaît ainsi que, lors de la surveillance de la qualité d'un programme de télévision, l'opérateur observe à l'écran du moniteur simultanément l'image du programme et le déplacement d'un index variable le long de la barre verticale, représentatif de l'amplitude du signal son.

En outre, le dispositif présente l'avantage que de nombreux réglages peuvent être effectués en fonction des caractéristiques du signal basse-fréquence à analyser et des moyens de visualisation vidéo. Ainsi, notamment, peuvent être réglés l'intervalle de la gamme de mesure, la position relative de la barre verticale par rapport aux bords verticaux de l'écran, la position relative de l'index fixe de référence et la largeur de la barre verticale. La position relative et la largeur de la barre verticale sont par exemple ajustées par modification d'au moins l'une des caractéristiques de la constante de temps d'une double bascule monostable.

En outre, lorsque le moniteur vidéo est un moniteur vidéo couleur, différentes couleurs primaires ou composites peuvent être sélectionnées pour visualiser l'index fixe et l'index variable représentatif de l'amplitude selon qu'il est au-dessus ou en dessous de l'index fixe.

D'autres avantages de la présente invention apparaîtront plus clairement à la lecture de la description qui suit de plusieurs exemples de réalisation et des dessins annexés correspondants, dans lesquels :

la Figure 1 est un bloc-diagramme détaillé du dispositif de mesure et de visualisation relatif au signal son d'un signal composite de télévision en couleurs ; et

la Figure 2 est un diagramme de formes d'onde qui sont produites dans le dispositif de la Fig. 1.

On décrit ci-après une réalisation préférée du dispositif de mesure et de visualisation de l'amplitude d'un signal basse-fréquence conforme à l'invention qui est relative au signal de la voie son basse-fréquence d'un signal composite de télévision en couleurs. L'amplitude instantanée du signal basse-fréquence est visualisée sur l'écran d'un moniteur vidéo couleur d'un studio de télévision en couleurs.

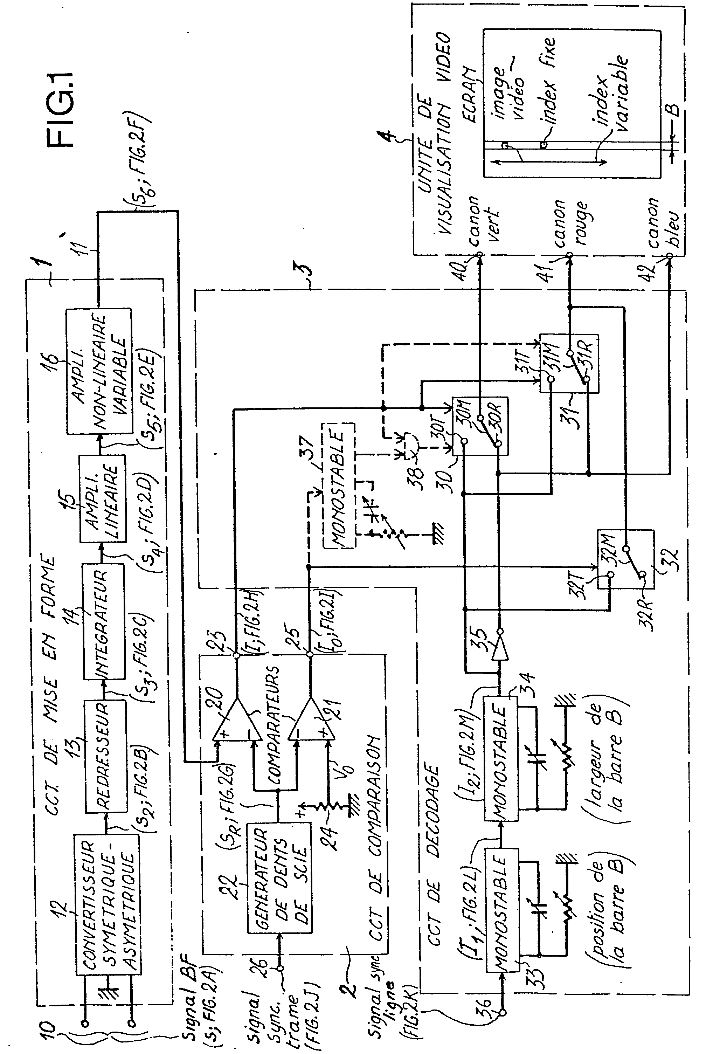

En se référant à la Fig. 1, le dispositif comprend essentiellement un circuit de mise en forme 1 du signal basse-fréquence S, un circuit de comparaison 2 qui compare l'amplitude de l'enveloppe du signal basse-fréquence à celle d'un signal de référence $S_R$, un circuit de décodage des résultats des comparaisons 3 et une unité de visualisation vidéo 4 pour visualiser les amplitudes relatives du signal basse-fréquence et du signal de référence.

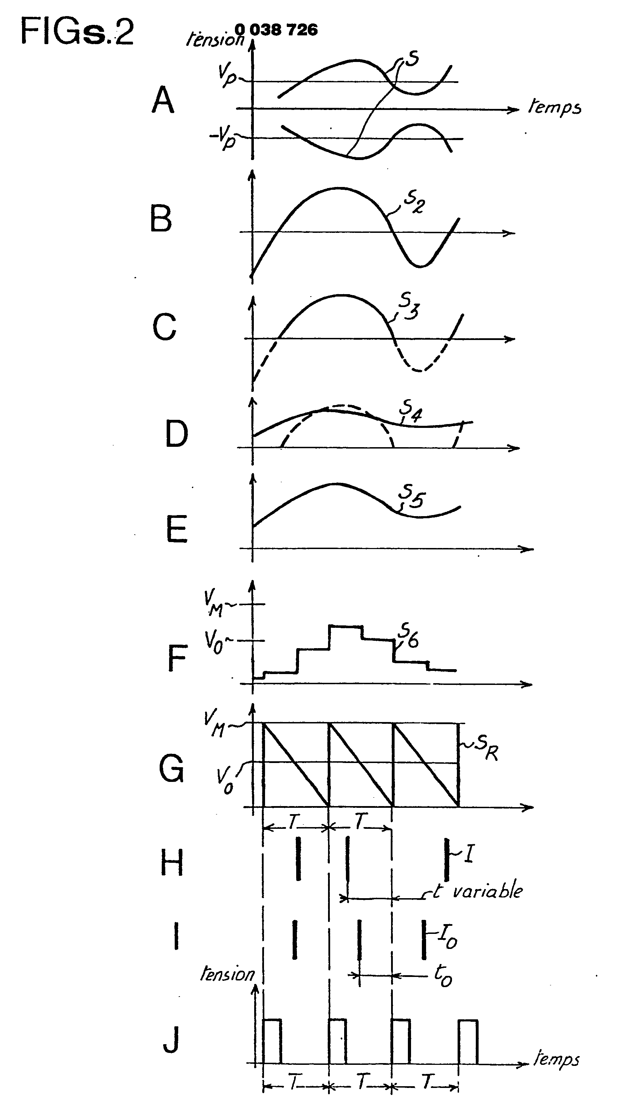

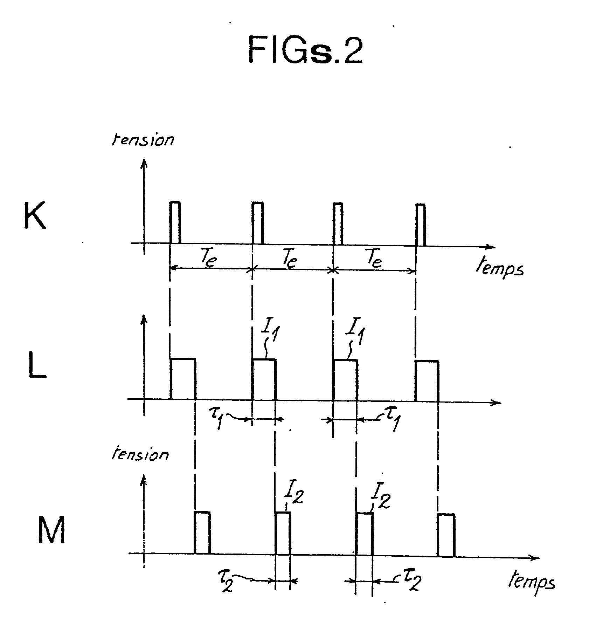

On notera par ailleurs, que les renvois entre parenthèses sur la Fig. 1 sont relatifs aux formes d'onde montrées aux Fig. 2A à 2M, respectivement.

Le circuit de mise en forme 1 restitue à sa sortie 11 l'enveloppe échantillonnée selon une loi logarithmique prédéterminée du signal basse-fréquence reçu à son entrée 10. En fait, le signal son basse-fréquence S montré à la Fig. 2A est composé de deux formes d'onde symétriques, respectivement polarisées à une tension de polarisation prédéterminée $V_p$ et à son opposée $- V_p$. Ce signal basse-fréquence composite S est désymétrisé dans un convertisseur symétrique-asymétrique 12 dont la sortie produit la forme d'onde $S_2$ initialement positive, mais avec une tension de polarisation nulle, telle que montrée à la Fig. 2B. Puis le signal $S_2$ est redressé dans un redresseur 13 en un signal $S_3$ montré à la Fig. 2C, qui correspond à une troncation des amplitudes négatives du signal $S_2$. Le signal $S_3$ est appliqué à l'entrée d'un intégrateur 14 ayant une constante d'intégration de l'ordre de 0,2 à 0,3 s. La valeur de la constante d'intégration est choisie de sorte qu'elle soit compatible avec l'inertie de l'aiguille d'un vumètre, afin que l'échelle de mesure soit analogue à celle d'un vumètre. Le signal sortant $S_4$ de l'intégrateur 14 reproduit sensiblement l'enveloppe du signal basse-fréquence $S_2$ et est montré à la Fig. 2D. Un amplificateur linéaire 15 amplifie avec un gain prédéterminé le signal $S_4$ en un signal $S_5$ montré à la Fig. 2E.

Le signal d'enveloppe amplifié $S_5$ est ensuite appliqué à l'entrée d'un amplificateur non linéaire 16 à gain variable relativement à des intervalles de tension prédéterminé. Cet amplificateur est analogue à un échantillonneur-bloqueur selon une loi de quantification logarithmique. Il présente une pluralité de pas de quantification pour chacun desquels une tension appliquée à l'entrée de l'amplificateur comprise dans le pas de quantification est amplifiée avec un gain porportionnel à la limite inférieure du pas de quantification, selon la loi de quantification logarithmique. En d'autres termes, plus l'amplitude du signal entrant $S_5$ est grande, plus le gain de l'amplificateur 16 est grand en proportion à une fonction logarithmique. Le signal sortant $S_6$ est de préférence échantillonné à la fréquence du signal périodique de référence $S_R$, ou à une fréquence multiple de celle-ci, comme montré à la Fig. 2F.

Le circuit de comparaison 2 comprend deux comparateurs de tension 20 et 21 et un générateur 22 qui produit le signal de référence $S_R$ sous la forme d'un signal en dents de scie montré à la Fig. 2G.

Le premier comparateur 20 reçoit respectivement à ses entrées directe (+) et inverse (−) le signal d'enveloppe échantillonné $S_6$ et le signal en dents de scie $S_R$. L'amplitude crête $V_M$ du signal $S_R$ est choisie de sorte qu'elle est toujours supérieure à l'amplitude du signal $S_6$. Ainsi, pour chaque période du signal $S_R$ de durée T, la sortie 23 du comparateur 20 produit une impulsion I à l'instant pour lequel il y a égalité des amplitudes des signaux $S_6$ et $S_R$. Comme le signal $S_R$ est un signal en dents de scie à tension décroissante linéairement jusqu'à zéro en fin de période, la durée t entre l'impulsion I et la fin de la période est proportionnelle à l'amplitude V du signal $S_6$ à l'instant $T - t$, comme montré à la Fig. 2H :

$$t = (V/V_M)T$$

Le second comparateur 21 compare l'amplitude du signal de référence en dents de scie $S_R$ délivré par le générateur 22 à son entrée inverse (−) et une tension de référence $V_0$ appliquée par un potentiomètre ou un diviseur de tension variable 24 à son entrée directe (+). La sortie 25 du comparateur 21 produit une impulsion $I_0$ lorsqu'il y a égalité de tensions sur ses entrées, tout comme le comparateur 20. L'impulsion $I_0$ dite de référence montrée à la Fig. 2I est inférieure à la fin de chaque période d'une durée $t_0$ telle que :

$$t_0 = (V_O/V_M)T$$

Si la tension $V_O$ est choisie de sorte qu'elle indique le seuil inférieur de surmodulation du signal son d'un signal composite vidéo, il apparaît que, pour toute impulsion I telle que $t \leqslant t_0$ produite sur la sortie 23, le signal basse-fréquence est présent et a une amplitude convenable et que, pour toute impulsion telle que $t > t_0$, le signal basse-fréquence présente une surmodulation indésirable.

La période T du signal de référence en dents de scie $S_R$ est égale à la période des trames d'un signal vidéo, par exemple 20 ms. Pour produire le signal $S_R$ en synchronisme avec les trames, le générateur 22 reçoit à son entrée 20 le signal de synchronisation de trame montré à la Fig. 2J.

Ainsi, pour chaque trame, une image de l'impulsion variable I peut être visualisée sur l'écran d'un moniteur vidéo, relativement à l'image fixe de l'impulsion de référence $I_0$. Pour ce faire, le circuit de décodage 3 détecte les deux lignes auxquelles appartiennent les impulsions I et $I_0$, pour chaque trame.

Le circuit de décodage comprend trois commutateurs 30, 31, 32, deux bascules monostables 33 et 34 et un inverseur 35. Bien que les commutateurs soient représentés schématiques par des contacts de relais à deux positions sur la Fig. 1, ils sont en pratique réalisés par des transistors.

Les commutateurs 30 et 31 sont mis au travail par les impulsions I délivrées par la sortie 23 du commutateur 20. Le commutateur 32 est mis au travail par les impulsions de référence $I_0$ délivrées par la sortie 25 du comparateur 21. Tous les contacts de travail $30_T$, $31_T$, et $32_T$ des commutateurs sont reliés à la sortie de la seconde bascule monostable 34. Le contact de repos $30_R$ du commutateur 30 est relié à la sortie de la bascule 34 à travers l'inverseur 35. Le contact mobile $31_M$ du commutateur 31 est relié au contact mobile $32_M$ du commutateur 32. Le contact mobile $30_M$ du commutateur 30 et les contacts mobiles $21_M$, $32_M$ des commutateurs 21 et 32 sont reliés respectivement à deux entrées vidéo 40 et 41 d'un moniteur vidéo couleur constituant l'unité de visualisation 4. Ces entrées vidéo correspondent par exemple aux canons vert et rouge.

Les bascules monostables 33 et 34 sont en série et sont respectivement sensibles aux fronts montants et descendants des impulsions qu'elles reçoivent. L'entrée 36 de la première bascule 33 reçoit le signal de synchronisation de ligne à période $T_l$, montré à la Fig. 2K. Elle produit une impulsion $I_1$ en réponse au front montant de chaque impulsion de synchronisation de ligne. Chaque impulsion $I_1$ telle que montrée à la Fig. 2L a une largeur prédéterminée $\tau_1$ afin que son front descendant corresponde au bord de gauche d'une barre verticale image B de l'écran du moniteur vidéo 4. En réponse au front descendant d'une impulsion $I_1$, la seconde bascule 34 délivre une impulsion $I_2$, telle que montrée à la Fig. 2M, vers les contacts de travail $30_T$, $31_T$ et $32_T$ et vers l'entrée de l'inverseur 35. Chaque impulsion $I_2$ a une largeur $\tau_2$ au moins égale à la période des points images afin que la barre verticale B ait une largeur au moins égale à un point image.

La visualisation de l'amplitude du signal basse-fréquence s'effectue de la manière suivante pour chaque trame. Si $t < t_0$, c'est-à-dire si $V < V_O$, l'impulsion $I_0$ de la trame met au travail le commutateur 32 après $T - t_0$ succédant au début de la trame, et l'impulsion $I_2$ correspondant à la ligne dite de référence définie par $I_0$ excite le canon rouge à travers le commutateur 32 au travail.

Puis après un nombre de ligne égale à $(t_0 - t)/T_l$, l'impulsion $I_2$ correspondant à la ligne définie par I excite les canons rouge et vert à travers les commutateurs 30 et 31. Par suite, l'image fixe indiquant la tension de référence $V_O$ est rouge dans la barre B et l'image variable indiquant l'amplitude du signal basse-fréquence à analyser est jaune et en dessous de l'image fixe rouge. On notera que, pour visualiser assurément à un endroit quelconque de la barre B les images fixe et mobile, les impulsions I et $I_0$ ont une largeur de préférence égale à la période de ligne $T_l$, et en général supérieure à $T_l - \tau_2$.

Pendant chaque trame, en dehors des instants de travail précédents des commutateurs 30 à 32, le signal résultant de l'inversion de l'impulsion $I_2$ par l'inverseur 35 est transmis à travers les commutateurs 30 et 31 au repos aux entrées vidéo 40 et 41 et directement à l'autre entrée vidéo 42 correspondant au bleu. Ainsi, les index images jaune et rouge sont visualisés sur une barre noire verticale B.

Dès que l'amplitude V est supérieure à $V_O$, c'est-à-dire $t > t_0$, l'index image variable jaune représentatif de l'impulsion I est au-dessus de l'index fixe rouge de référence.

Selon une autre variante, la couleur de l'index variable peut être modifiée, dès que l'amplitude du signal $S_6$ est supérieure au seuil $V_O$. Par exemple, en vue d'attirer l'attention de l'opérateur, l'index variable peut être rouge au-dessus de l'index fixe rouge, et jaune en dessous, comme précédemment. Dans ce cas, le circuit de décodage 3 comporte les éléments représentés en traits interrompus sur la Fig. 1 Ces éléments sont une bascule monostable 37 recevant les impulsions I qui sont également transmises vers l'entrée de commande du commutateur 32, et une porte ET 38 dont les entrées sont reliées à la sortie de la bascule 37 et à la sortie 23 du comparateur 20. Dans ce cas, le commutateur 30 est uniquement commandé par les impulsions sortant de la porte ET 38, et le commutateur 31 est commandé uniquement par les impulsions I sortant du comparateur 20. Si la constante de temps de la bascule monostable 37 est égale à $t_0$, il en résulte que, pour $t > t_0$, la porte ET 38 reste fermée et qu'uniquement le commutateur 31 peut être mis au travail par l'impulsion I, ce qui provoque l'affichage d'un index rouge d'alarme au-dessus de l'index fixe rouge.

On notera que toutes les bascules monostables 33, 34 et 37 peuvent comprendre un condensateur ajustable et/ou une résistance ajustable afin d'ajuster leur constante de temps, c'est-à-dire la largeur des impulsions produites. En particulier, la constante de temps de la bascule monostable 37 est ajustée en proportion de la valeur $V_O$ ajustée par le potentiomètre 24. La bascule 33 détermine l'emplacement de la barre verticale B sur l'écran, qui est généralement choisie près du bord vertical gauche ou droit de l'écran. La bascule 34 détermine la largeur de la barre B, pratiquement égale à quelques points images.

Ainsi, les paramètres précités peuvent être choisis pour la visualisation du signal son du signal vidéo couleur selon le procédé SECAM :

— période de trame = T = 20 ms ;

— période de ligne = $T_l$ = 64 µs ;
— définition d'une image = 520 points images par ligne parmi 402 ;
— durée utile d'une ligne = 52 µs ;
— période de points = 0,1 µs ;
— $\tau_1$ = 5 µs : début de la barre B après 50 points à partir du bord gauche de l'écran ;
— $\tau_2$ = 2 µs : largeur de la barre B égale à 20 points ;
— réglage du potentiomètre 24 pour un niveau de référence $V_0$ = 4 dB (correspondant au zéro d'un vumètre) ;
— gamme d'amplitudes mesurées : — 18 à + 15 dB.

On notera qu'en pratique, entre les contacts mobiles $30_M$, $31_M$ et la sortie de l'inverseur 35, d'une part, et les entrées vidéo 40, 41 et 42 des canons couleurs, un mélangeur vidéo est inséré afin de visualiser sur l'écran du moniteur vidéo aussi bien la barre B que l'image vidéo d'un programme de télévision en couleurs, dont le signal son est appliqué à l'entrée 10 du dispositif.

Bien que le dispositif ait été décrit en référence à une réalisation préférée, d'autres variantes facilement imaginables par l'homme de l'art peuvent être conçues dans le cadre des revendications annexées. En particulier, on notera que le circuit de mise en forme 1 n'est pas indispensable ; ainsi le dispositif peut comprendre au moins l'un des éléments suivants reliés en série à l'entrée 11 du premier comparateur 20 recevant un signal fonction du signal-basse fréquence S, à savoir un redresseur tel que 13, un intégrateur jouant le rôle de détecteur d'enveloppe tel que 14, un amplificateur linéaire tel que 15, et un amplificateur non linéaire à gain variable tel que 16. Lorsqu'on désire visualiser les variations réelles d'amplitude d'un signal basse-fréquence, sans faire appel à une échelle logarithmique, l'amplificateur 16 est supprimé ; en fait, l'échelle logarithmique obtenue au moyen de l'amplificateur non linéaire 16 a été choisie afin d'effectuer des mesures en décibels, par étalonnage préalable de la hauteur de la barre verticale B sur l'écran du moniteur vidéo, en analogie avec le cadran d'un vumètre classique, qui est généralement utilisé dans les studios de télédiffusion pour le contrôle visuel de la profondeur de modulation du signal son.

En outre, le signal de référence périodique en dents de scie peut être à tension linéaire croissante, et le moniteur vidéo peut être un moniteur vidéo noir et blanc auquel cas les contacts mobiles $30_M$, $31_M$ et $32_M$ sont reliés à l'entrée vidéo du moniteur. Pour l'emploi d'un moniteur vidéo, les commutateurs et d'autres (non représentés) du circuit de décodage 3 peuvent être sélectionnés pour attribuer d'autres couleurs primaires ou composites que celles précitées, aux index variable et fixe et au fond de la barre verticale B.

## Revendications

1. Dispositif de mesure et de visualisation de l'amplitude d'un signal basse-fréquence (S) comprenant des moyens de visualisation vidéo (4) définissant une période de trame (T) et une période de ligne ($T_l$), et des moyens (22) pour produire un signal périodique en dents de scie ($S_R$), caractérisé en ce que le signal en dents de scie ($S_R$) a sa période égale à la période de trame (T) et est synchrone du signal de synchronisation de trame (J), et en ce que le dispositif comprend des premiers moyens de comparaison de tension (20) recevant ledit signal basse-fréquence (S) ou un signal ($S_6$) ayant une amplitude fonction du signal basse-fréquence selon une loi de variation prédéterminée et ledit signal en dents de scie ($S_R$) pour produire des premières impulsions (I) aux instants d'égalité des amplitudes des deux signaux reçus (S ou $S_6$, $S_R$), une source (33) de secondes impulsions récurrentes à la période de ligne ($T_l$) et des premiers moyens de commutation (30, 31) commandés par les premières impulsions (I) pour transmettre l'une desdites secondes impulsions ($I_2$) vers des moyens d'entrée vidéo (40, 41) des moyens de visualisation vidéo (4) en réponse à la détection de chaque première impulsion (I), la largeur des premières impulsions (I) étant supérieure à la différence de la période de ligne ($T_l$) et de la largeur des secondes impulsions ($I_2$).

2. Dispositif conforme à la revendication 1, caractérisé en ce qu'il comprend une première bascule monostable (33) recevant les impulsions de synchronisation de ligne (K) pour produire des troisièmes impulsions ($I_1$) en réponse aux impulsions de synchronisation de ligne, et une seconde bascule monostable (34) en série avec la première bascule monostable (33) pour produire lesdites secondes impulsions ($I_2$) en réponse au front descendant desdites troisièmes impulsions ($I_1$), et en ce que les premiers moyens de commutation (30, 31) relient la sortie de la seconde bascule monostable (34) aux moyens d'entrée vidéo (40, 41) pendant la durée des premières impulsions (I).

3. Dispositif conforme à la revendication 2, caractérisé en ce qu'il comprend des moyens (35) d'inversion desdites secondes impulsions ($I_2$) qui sont reliés à travers les premiers moyens de commutation (30, 31) aux moyens d'entrée vidéo (40, 41) pendant la durée complémentaire à la durée des premières impulsions (I).

4. Dispositif conforme à la revendication 2 ou 3, caractérisé en ce qu'il comprend des moyens pour ajuster au moins l'une des caractéristiques (R, C) de la constante de temps ($\tau_1$) de la première bascule monostable (33) et/ou des moyens pour ajuster au moins l'une des caractéristiques (R, C) de la constante de temps ($\tau_2$) de la seconde bascule monostable (34).

5. Dispositif conforme à l'une des revendications 1 à 4, caractérisé en ce que les secondes impulsions ($I_2$) ont une largeur ($\tau_2$) telle que chacune est représentative de la portion de ligne d'une barre image verticale (B) ayant une largeur d'un ou de plusieurs points images.

6. Dispositif conforme à l'une des revendications 1 à 5, caractérisé en ce qu'il comprend des seconds moyens de comparaison de tension (21) recevant ledit signal en dents de scie ($S_R$) et une tension de référence ajustable ($V_O$) pour produire des impulsions de référence ($I_0$) aux instants d'égalité de l'amplitude du signal en dents de scie ($S_R$) avec la tension de référence ($V_O$), et des seconds moyens de commutation (32) commandés par les impulsions de référence ($I_0$) pour transmettre l'une desdites secondes impulsions ($I_2$) vers lesdits moyens d'entrée vidéo (41) en réponse à la détection de chaque impulsion de référence ($I_0$), la largeur des impulsions de référence ($I_0$) étant supérieure à la différence de la période de ligne ($T_l$) et de la largeur des secondes impulsions ($I_2$).

7. Dispositif conforme à l'une des revendications 1 à 6, caractérisé en ce que les moyens de visualisation vidéo sont un moniteur vidéo (4).

8. Dispositif conforme aux revendications 2 et 7, caractérisé en ce que le moniteur vidéo (4) est un moniteur vidéo en couleurs et en ce que les premiers moyens de commutation (30, 31) relient les moyens d'entrée vidéo relatifs à une couleur primaire ou composite (40, 41), à la sortie de la seconde bascule monostable (34) uniquement pendant la durée des premières impulsions (I).

9. Dispositif conforme aux revendications 6 et 8, caractérisé en ce que les seconds moyens de commutation (32) relient les moyens d'entrée vidéo relctifs à une seconde couleur primaire ou composite (40, 41), à la sortie de la seconde bascule monostable (34) uniquement pendant la durée des impulsions de référence ($I_0$).

10. Dispositif conforme à la revendication 8 ou 9, caractérisé en ce qu'il comprend des moyens (37-38) recevant lesdites premières impulsions (I) et lesdites impulsions de référence ($I_0$) pour relier les moyens d'entrée vidéo relatifs à une troisième couleur primaire ou composite (40, 41) à la sortie de la seconde bascule monostable (34) uniquement pendant la durée des premières impulsions (I) précédant les impulsions de référence ($I_0$) respectives dans les périodes de trame (T).

11. Dispositif conforme à l'une des revendications 1 à 10, caractérisé en ce qu'il comprend, en outre, au moins l'un des éléments suivants reliés en série à l'entrée (11) des premiers moyens de comparaison (20) recevant un signal fonction du signal basse-fréquence : un redresseur (13), un détecteur d'enveloppe (14), un amplificateur linéaire (15) et un amplificateur non linéaire à gain variable (16).

12. Dispositif conforme à la revendication 11, caractérisé en ce qu'il comprend en amont desdits éléments (13-16), un convertisseur symétrique-asymétrique (12) recevant le signal basse-fréquence.

## Claims

1. Device for measuring and visualizing the amplitude of a low frequency signal (S), said device comprising video visualizing means (4) defining a field period (T) and a line period ($T_l$), and means (22) for deriving a periodic saw-tooth signal ($S_R$), characterized in that the saw-tooth signal ($S_R$) has its period equal to the field period (T) and is synchronous with the field synchronizing signal (J), and in that the device comprises first voltage comparing means (20) receiving said low frequency signal (S) or a signal ($S_6$) having an amplitude depending on the low frequency signal according to a predetermined variation law and said saw-tooth signal ($S_R$) for deriving first pulses at times corresponding to the equality of the amplitudes of the two received signals (S or $S_6$, $S_R$), means (33) for producing second pulses recurrent with the line period ($T_l$), and first switching means (30, 31) controlled by the first pulses (I) for transmitting one of said second pulses ($I_2$) to input video means (40, 41) of the video visualizing means (4) in response to the detection of each first pulse (I), the width of the first pulses (I) being greater than the difference between the line period ($T_l$) and the width of second pulses ($I_2$).

2. Device according to claim 1, characterized in that it comprises a first monostable flip-flop (33) receiving the line synchronizing pulses (K) for deriving third pulses ($I_1$) in response to the line synchronizing pulses, and a second monostable flip-flop (34) series-connected to the first monostable flip-flop (33) for deriving said second pulses ($I_2$) in response to the fall front of said third pulses ($I_1$), and in that the first switching means (30, 31) connect the output of the second monostable flip-flop (34) to the input video means (40, 41) throughout the duration of the first pulses (I).

3. Device according to claim 2, characterized in that it comprises means (35) connected to the input video means (40, 41) through the first switching means (30, 31) throughout the complementary duration to the duration of the first pulses (I) for inverting said second pulses ($I_2$).

4. Device according to claim 2 or 3, characterized in that it comprises means for adjusting at least one of the characteristics (R, C) of the time constant ($\tau_1$) of the first monostable flip-flop (33) and/or means for adjusting at least one of the characteristics (R, C) of the time constant ($\tau_2$) of the second monostable flip-flop (34).

5. Device according to one of claims 1 to 4, characterized in that the second pulses ($I_2$) have a width ($\tau_2$) such that each thereof is representative of the line portion of a vertical picture bar (B) having a width including one or several picture elements.

6. Device according to one of claims 1 to 5, characterized in that it comprises second voltage comparing means (21) receiving said saw-tooth signal ($S_R$) and an adjustable reference voltage ($V_O$) for deriving reference pulses ($T_O$) at times corresponding to the equality between the saw-tooth signal amplitude ($S_R$) and the reference voltage ($V_O$), and second switching means (32) controlled by the reference pulses ($I_0$) for transmitting one of said second pulses ($I_2$) to said input video means (41) in response to the detec-

11    0 038 726    12

tion of each reference pulse ($I_0$), the width of the reference pulses ($I_0$) being greater than the difference between the line period ($T_l$) and the width of the second pulses ($I_2$).

7. Device according to one of claims 1 to 6, characterized in that the video visualizing means are a video monitor (4).

8. Device according to claims 2 and 7, characterized in that the video monitor (4) is a color video monitor and in that the switching means (30, 31) connect the input video means relative to a primary or composite color (40, 41), to the output of the second monostable flip-flop (34) only throughout the duration of the first pulses (I).

9. Device according to claims 6 and 8, characterized in that the second switching means (32) connect the input video means relative to a second primary or composite color (40, 41), to the output of the second monostable flip-flop (34) only throughout the duration of the reference pulses ($I_0$).

10. Device according to claim 8 or 9, characterized in that it comprises means (37-38) receiving said first pulses (I) and said reference pulses ($I_0$) for connecting the input video means relative to a third primary or composite color (40, 41) to the output of the second monostable flip-flop (34) only throughout the duration of the first pulses (I) preceding the respective reference pulses ($I_0$) in the field periods (T).

11. Device according to one of claims 1 to 10, characterized in that it further comprises at least one of following members series-connected to the first comparing means (20) input (11) receiving a signal depending on the low frequency signal : a rectifier (13), an envelope detector (14), a linear amplifier (15) and a variable gain nonlinear amplifier (16).

12. Device according to claim 11, characterized in that it comprises upstream said members (13-16), a symmetrical-asymmetrical converter (12) receiving the low frequency signal.

**Ansprüche**

1. Meß- und Wiedergabeeinrichtung für die Amplitude eines niederfrequenten Signals mit einer Videowiedergabeeinrichtung (4), die eine Teilbildperiode (T) und eine Zeilenperiode ($T_l$) definiert, und mit einer Einrichtung (22) für die Erzeugung eines periodischen Sägezahnsignals ($S_R$), dadurch gekennzeichnet, daß die Periode des Sägezahnsignals ($S_R$) gleich der Teilbildperiode (T) und mit dem Teilbildsynchronisationssignal (J) synchronisiert ist, und daß die Einrichtung einen ersten Spannungskomparator (20) für die Aufnahme des niederfrequenten Signals (S) oder eines Signals ($S_6$) mit einer von dem niederfrequenten Signal nach einer vorbestimmten Änderungsfunktion abhängigen Amplitude und des Sägezahnsignals ($S_R$) für die Erzeugung von ersten Impulsen (I) in den Zeitpunkten der Amplitudengleichheit der beiden empfangenen Signale (S, oder $S_6$, $S_R$) sowie eine Quelle (33) für zweite, sich mit der Zeilenperiode ($T_l$) wiederholende Impulse und eine erste Schalteinrichtung (30, 31) umfaßt, die von den ersten Impulsen (I) für die Übertragung eines der zweiten Impulse ($I_2$) zu den Videoeingängen (40, 41) der Videowiedergabeeinrichtung (4) in Abhängigkeit von der Feststellung jedes ersten Impulses (I), wobei die Breite der ersten Impulse (I) größer ist als die Differenz der Zeilenperiode ($T_l$) und der Breite der zweiten Impulse ($I_2$).

2. Einrichtung nach Anspruch 1, dadurch gekennzeichnet, daß sie eine erste monostabile Kippstufe (33) für den Empfang der Zeilensynchronisationsimpulse zur Erzeugung dritter Impulse ($I_1$) in Abhängigkeit von den Zeilensynchronisationsimpulsen und eine zweite, mit der ersten monostabilen Kippstufe (33) in Reihe liegende monostabile Kippstufe (34) für die Erzeugung der zweiten Impulse ($I_2$) in Abhängigkeit von den fallenden Signalflanken der dritten Impulse ($I_1$) umfaßt, und daß die ersten Schalteinrichtungen (30, 31) den Ausgang der zweiten monostabilen Kippstufe (34) mit den Videoeingängen (40, 41) während der Dauer der ersten Impulse (I) verbinden.

3. Einrichtung nach Anspruch 2, dadurch gekennzeichnet, daß sie eine Invertereinrichtung (35) für die zweiten Impulse ($I_2$) aufweist, die über die ersten Schalteinrichtungen (30, 31) mit den Videoeingängen (40, 41) während des zu der Impulsdauer der ersten Impulse (I) komplementären Zeitraums verbunden ist.

4. Einrichtung nach Anspruch 2 oder 3, dadurch gekennzeichnet, daß sie eine Einstelleinrichtung für die Einstellung mindestens einer der Größen (R, C) der Zeitkonstante ($\tau_1$) der ersten monostabilen Kippstufe (33) und/oder eine Einstelleinrichtung für die Einstellung mindestens einer der Größen (R, C) der Zeitkonstante ($\tau_2$) der zweiten monostabilen Kippstufe (34) umfaßt.

5. Einrichtung nach einem der Ansprüche 1 bis 4, dadurch gekennzeichnet, daß die zweiten Impulse ($I_2$) eine solche Breite ($\tau_2$) besitzen, die jeweils repräsentativ ist für den Zeilenabschnitt eines vertikalen Bildstreifens (B) mit der Breite eines oder mehrerer Bildpunkte.

6. Einrichtung nach einem der Ansprüche 1 bis 5, dadurch gekennzeichnet, daß sie einen zweiten Spannungskomparator (21) für den Empfang des Sägezahnsignals und einer einstellbaren Bezugsspannung ($V_0$) zur Erzeugung von Bezugsimpulsen ($I_0$) in den Zeitpunkten der Amplitudengleichheit des Sägezahnsignals ($S_R$) mit der Bezugsspannung ($V_0$) und eine zweite Schalteinrichtung (32) umfaßt, die von den Bezugsimpulsen ($I_0$) für die Übertragung eines der zweiten Impulse ($I_2$) zu dem Videoeingang (41) in Abhängigkeit von der Feststellung jedes Bezugsimpulses ($I_0$) gesteuert wird, wobei die Breite der Bezugsimpulse ($I_0$) größer ist als die Differenz der Zeilenperiode ($T_l$) und der Breite der zweiten Impulse ($I_2$).

7. Einrichtung nach einem der Ansprüche 1 bis 6, dadurch gekennzeichnet, daß die Videowie-

7

dergabeeinrichtung ein Bildmonitor (4) ist.

8. Einrichtung gemäß Ansprüchen 2 und 7, dadurch gekennzeichnet, daß der Bildmonitor (4) ein Farbbildmonitor ist und daß die ersten Schalteinrichtungen (30, 31) die zu einer Primärfarbe oder zusammengesetzten Farbe zugeordneten Eingänge (40, 41) mit dem Ausgang der zweiten monostabilen Kippstufe (34) lediglich während der Impulsdauer der Bezugsimpulse (I$_0$) verbinden.

9. Einrichtung gemäß Ansprüchen 6 und 8, dadurch gekennzeichnet, daß die zweiten Schalteinrichtungen (32) die su einer zweiten Primärfarbe oder zusammengesetzten Farbe zugeordneten Engänge (40, 41) mit dem Ausgang der zweiten monostabilen Kippstufe (34) lediglich während der Impulsdauer der Bezugsimpulse (I$_0$) verbinden.

10. Einrichtung gemäß Anspruch 8 oder 9, dadurch gekennzeichnet, daß sie Empfangseinrichtungen (37-38) für die ersten Impulse (I) und die Bezungsimpulse (I$_0$) umfaßt, um die Videoein-

gänge (40, 41) für eine dritte Primärfarbe oder zusammengesetzte Farbe mit dem Ausgang der zweiten monostabilen Kippstufe (34) lediglich während der den jeweiligen Bezugsimpulsen (I$_0$) in den Teilbildperioden (T) vorangehenden Impulsdauer der ersten Impulse (I) zu verbinden.

11. Einrichtung nach einem der Ansprüche 1 bis 10, dadurch gekennzeichnet, daß sie des weiteren mindestens eines der folgenden Elemente in Reihenschaltung mit dem Eingang (11) der ersten Komparatoreinrichtung (20) für die Aufnahme eines Signals in Abhängigkeit von dem niederfrequenten Signal umfaßt: einen Gleichrichter (13), einen Hüllkurvendetektor (14), einen Linearverstärker (15) und einen nichtlinearen Verstärker (16) mit veränderlichem Verstärkungsgrad.

12. Einrichtung nach Anspruch 1, dadurch gekennzeichnet, daß sie zusätzlich zu den Elementen (13-16) einen die niederfrequenten Signale aufnehmenden Symmetrie-Asymmetrie-Umsetzer (12) umfaßt.

FIG.1

**CCT. DE MISE EN FORME**

10 — Signal BF ($s$; FIG.2A)

12 — CONVERTISSEUR SYMETRIQUE-ASYMETRIQUE

13 — REDRESSEUR ($s_2$; FIG.2B)

14 — INTEGRATEUR ($s_3$; FIG.2C)

15 — AMPLI. LINEAIRE ($s_4$; FIG.2D)

16 — AMPLI. NON-LINEAIRE VARIABLE ($s_5$; FIG.2E)

11 — ($s_6$; FIG.2F)

1

signal sync. trame (FIG.2J) — 26

22 — GENERATEUR DE DENTS DE SCIE ($s_R$; FIG.2G)

24 — $V_0$

COMPARATEURS

20 — 23 ($I$; FIG.2H)

21 — 25 ($I_0$; FIG.2I)

2 — CCT DE COMPARAISON

37 — MONOSTABLE

38

3

Signal sync ligne (FIG.2K)

**CCT DE DECODAGE**

36

33 — MONOSTABLE ($I_1$; FIG.2L) (position de la barre B)

34 — MONOSTABLE ($I_2$; FIG.2M) (largeur de la barre B)

35

30 — 30T / 30M / 30R

31 — 31T / 31M / 31R

32 — 32T / 32M / 32R

4 — UNITE DE VISUALISATION VIDEO

40 — canon vert

41 — canon rouge

42 — canon bleu

ECRAN

image vidéo

index fixe

index variable

B

0 038 726

FIGs.2

0 038 726

# FIGs.2